# EUROPÄISCHE PATENTSCHRIFT

(11) **EP 0 839 403 B1**
(45) Veröffentlichungstag und Bekanntmachung des Hinweises auf die Patenterteilung: **07.01.1999**
(21) Anmeldenummer: 96922753.7
(22) Anmeldetag: 08.07.1996
(51) Int. Cl.: H02M 7/00

(54) **LEISTUNGSHALBLEITER-BAUSTEIN**
POWER SEMICONDUCTOR MODULE
MODULE A SEMI-CONDUCTEUR DE PUISSANCE

(30) Priorität: 17.07.1995 DE 29511510 U
(43) Veröffentlichungstag der Anmeldung: 06.05.1998
(73) Patentinhaber: SIEMENS AKTIENGESELLSCHAFT, 80333 München (DE)
(72) Erfinder: LIPS, Hans-Peter, D-91325 Adelsburg (DE)
(86) Internationale Anmeldenummer: DE9601228
(87) Internationale Veröffentlichungsnummer: WO9704518

(56) Entgegenhaltungen:
- DE-A- 4 338 277
- IEEE/CSEE JOINT CONFERENCE ON HIGH VOLTAGE TRANSMISSION SYSTEMS IN CHINA 17 Oktober 1987, BEIJING, CHINA, Seiten 520 - 526, XP002016979 'State-of-the-art thyristor valves for China's first HVDC transmission system'
- IEEE TRANSACTIONS ON POWER APPARATUS AND SYSTEMS Bd. PAS-94, Nr. 3, Juni 1975, Seiten 1061 - 1071, XP002016977 'Cabora Bassa HVDC transmission: oil cooled outdoor thyristor valves'
- IEEE SPECTRUM Bd. 19, Nr. 12, Dezember 1992, Seiten 40 - 45, XP002016978 'Thyristors: future workhorses in power transmission'

## Beschreibung

Die Erfindung bezieht sich auf einen Leistungshalbleiter-Baustein mit wenigstens einem Leistungshalbleiterschalter, einer Kühleinrichtung, einer Steuerelektronik und einem Entlastungsnetzwerk.

In Hochspannungsanwendungen der Leistungselektronik, wie z.B. der Hochspannungs-Gleichstromübertragung (HGÜ), der Statischen Blindleistungskompensation (SVC) und in Hochspannungs-Drehzahlveränderlichen Antrieben werden üblicherweise mehrere Leistungshalbleiter mit ihren Kühleinrichtungen, Steuerelektroniken und Entlastungsnetzwerken elektrisch in Reihe geschaltet, um eine ausreichende Spannungsfestigkeit zu erzielen. Dabei wird die Kombination aus Leistungshalbleiter und zugehöriger Kühleinrichtung, Steuerelektronik und Entlastungsnetzwerk als Thyristorplatz bezeichnet. Mehrere derartige Thyristorplatze werden mechanisch in einem Modul zusammengefaßt, wobei die Modulkonstruktion die Erfordernisse der elektrischen Isolation der Bauteile untereinander und die mechanischen Anforderungen erfüllen muß.

Ein derartiges Modul ist beispielsweise aus der Zeitschrift "IEEE Transactions on Power Apparatus and systems", Vol. PAS-94, No. 3, May/June 1975, Seiten 1061 bis 1071, bekannt. Zwei Ausführungsformen für niedrige und hohe Gleichspannung sind im Siemens-Prospekt "Hochspannungs-Gleichstrom-Übertragung (HGÜ)", Bestell-Nr. E50001-U131-A35, Druckvermerk PA 3942., dargestellt.

Die eingangs genannte Veröffentlichung bezieht sich auf eine Hochspannungs-Gleichstrom-Übertragungsanlage (HGÜ-Anlage), deren Ventile einer Phase in einem Ölkessel angeordnet sind. Diese Ölkessel sind im Freien aufgestellt. Jedes Ventil besteht aus bis zu 20 Leistungshalbleiter-Modulen. In dieser Veröffentlichung wird ebenfalls ein Entlastungsnetzwerk, ein Prinzipschaltbild einer Steuerschaltung und die Kesselanordnung veranschaulicht und beschrieben. Der Kessel mit seiner Ölfüllung übernimmt in der genannten Veröffentlichung die Aufgabe, die Thyristorplatze gegen die mechanische Konstruktion der Module und des gesamten Ventils elektrisch zu isolieren und alle Komponenten gegen Umwelteinflüsse abzuschirmen.

Im Konferenzbeitrag mit dem Titel "State-Of-The-Art Thyristor Valves For China's First HVDC Transmission System" der IEEE/ CSEE Joint Conference on High Voltage Transmission Systems in China, Beijing, October 17 - 22, 1987, Seiten 520 bis 528, wird eine Hochspannungs-Gleichstrom-Übertragungs-Anlage vorgestellt, die wassergekühlte Ventile verwendet, die hängend in einem Gebäude untergebracht sind. In diesem Konferenzbeitrag ist der Aufbau einer Moduleinheit beschrieben. Außerdem ist die Steuerelektronik eines Leistungshalbleiters und die Fußpunktelektronik zur optischen Übertragung der Ansteuerimpulse dargestellt.

Im Siemens-Prospekt "Advanced Series Compensation", Bestell-Nr. E50001-U132-A22-X-7600, Druckvermerk PA 1932, ist eine weitere Ausführungsform der Anordnung von Leistungshalbleiter-Modulen dargestellt, wobei die Module zum Schalten von Kondensatoren dienen und in einem speziellen begehbaren Container auf einer Isolierplattform zusammen mit den Kondensatoren und Drosselspulen einer Serienkompensationsanlage angeordnet sind.

Das technische Problem der elektrischen Isolation der Thyristorplätze, insbesondere, wenn zum Erzielen hoher Spannungfestigkeiten mehrere Thyristorplatze elektrisch in Reihe geschaltet sind, sowie das weitere technische Problem der Schutzmaßnahmen gegen Umwelteinflüsse werden bei den beschriebenen Ausführungsformen der Stromrichteranlagen dadurch gelöst, daß komplette Stromrichter in Gerüsten angeordnet und in einem speziellen Gebäude oder Container oder Schrank luftisoliert untergebracht sind, oder in Kesseln angeordnet sind, die mit einer Isolierflüssigkeit oder mit Luft gefüllt sind. Diese Lösungen haben den Nachteil, daß auch für Stromrichter kleiner Leistung relativ teuere Gebäude gebraucht werden, die zudem häufig umständliche Genehmigungsverfahren erfordern bzw. daß der mit Isolierflüssigkeit oder -gas gefüllte Kessel geöffnet werden muß, um einzelne defekte Komponenten zu ersetzen, was hohen Personalaufwand erfordert.

Der Erfindung liegt nun die Aufgabe zugrunde, einen eingangs genannten Thyristorplatz derart weiterzubilden, daß die genannten Probleme ohne größeren Aufwand gelöst werden.

Diese Aufgabe wird gemäß Anspruch 1 dadurch gelöst, daß diese Komponenten mit einem isolierenden Medium zu einem massiven Block vergossen sind, aus dem Anschlüsse des Leistungshalbleiters, der Steuerelektronik und der Kühleinrichtung herausragen.

Durch diese erfindungsgemäße Weiterbildung eines eingangs genannten Thyristorplatzes zu einem Leistungshalbleiter-Baustein besteht nun die Möglichkeit, diese Bausteinblöcke, ähnlich wie bei einer Hochspannungs-Kondensatorbatterie, in einem Freiluftgerüst anzuordnen und zu verschalten oder sie beim Schalten von Kondensatoren direkt einzelnen Kondensatorbatterien zuzuordnen. Dadurch erübrigt sich ein Gebäude bzw. Container bzw. Schrank oder Kessel. Bei Defekten einzelner Komponenten eines Bausteinblocks wird dieser Bausteinblock ausgetauscht.

Diese erfindungsgemäße Lösung ist besonders dann vorteilhaft, wenn als Leistungshalbleiter direkt lichtzündbare Leistungshalbleiter verwendet werden, da dann die steuerelektronik mit ihrer Vielzahl von elektronischen Bauelementen entfällt. Dadurch sinkt einerseits die Ausfallwahrscheinlichkeit und die Bausteine werden besonders kompakt.

Ein weiterer Vorteil dieses erfindungsgemäßen Leistungshalbleiter-Bausteins besteht darin, daß spezielle Vorkehrungen zur Luftreinhaltung, die bei heutigen luftisolierten Ausführungen notwendig sind, entfallen. Die isolierende Vergußmasse kapselt die Komponenten des Leistungshalbleiter-Bausteins von der Umgebung ab, wodurch keine Verschmutzung der Komponenten auftritt, die für Koronaerscheinung oder Teil-Entladung und elektrische Überschläge verantwortlich sind.

Zur weiteren Erläuterung der Erfindung wird auf die Zeichnung Bezug genommen, in der ein Ausführungsbeispiel schematisch veranschaulicht ist.
- Figur 1: zeigt in einer vereinfachten Darstellung einen erfindungsgemäßen Leistungshalbleiter-Baustein, wogegen die
- Figur 2: in einer vereinfachten Darstellung einen Leistungshalbleiter-Ventilbaustein zeigt.

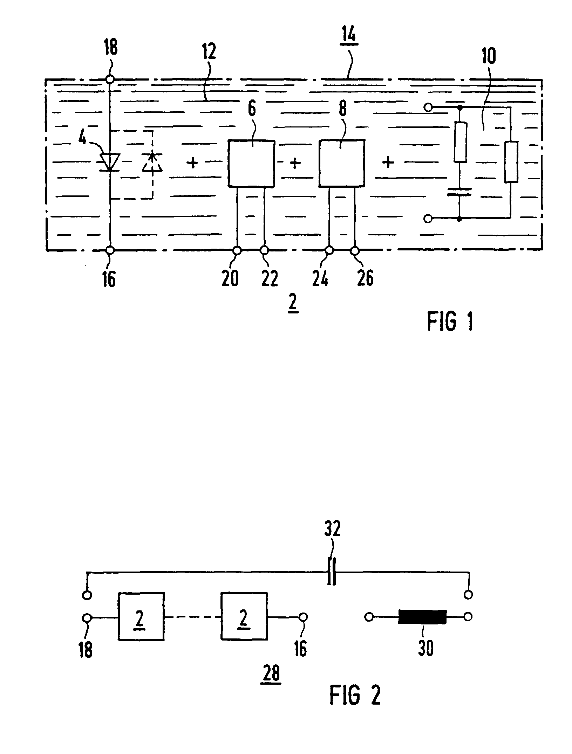

Der Leistungshalbleiter-Baustein 2 gemäß Figur 1 enthält wenigstens einen Leistungshalbleiterschalter 4, beispielsweise einen Thyristor, dem eine Steuerelektronik 6, auch als Thyristorelektronik bezeichnet, eine Kühleinrichtung 8 und ein Entlastungsnetzwerk 10 zugeordnet ist. Die Thyristorelektronik 6 entspricht beispielsweise der bekannten Thyristorelektronik, die im eingangs genannten Konferenzbeitrag vorgestellt ist. Das Entlastungsnetzwerk 10 entspricht entweder beispielsweise dem aus dem Konferenzbeitrag bekannten Entlastungsnetzwerk oder dem bekannten Entlastungsnetzwerk, das in der eingangs genannten Zeitschrift "IEEE Transactions on Power Apparatus and Systems" dargestellt ist. Die Kühleinrichtung 8 kann beispielsweise aus wenigstens einer Kühldose, einer Spannvorrichtung und mehreren Kühlmittelleitungen bestehen. Diese Komponenten 4, 6, 8 und 10 des Leistungshalbleiter-Bausteins 2 sind miteinander elektrisch und mechanisch verbunden. Dieser Komponentenverbund wird mit einem isolierenden Medium 12 zu einem massiven Block 14 vergossen. Aus diesem Gußblock 14 reichen folgende Anschlüsse: Stromanschlüsse 16, 18, Steueranschlüsse 20, 22 und Kühlmittelanschlüsse 24, 26 heraus. Durch die Vergußmasse sind die Komponenten 4, 6, 8 und 10 des Leistungshalbleiter-Bausteins 2 von der Umwelt abgekapselt, so daß diese Komponenten 4, 6, 8 und 10 nicht mehr den Umwelteinflüssen ausgesetzt sind. Als isolierendes Medium 12 kann beispielsweise Kunststoff verwendet werden, wobei Epoxydharz dem Block die nötige Steifigkeit verleiht.

Mehrere dieser Leistungshalbleiter-Bausteine 2 gemäß Figur 1, die jeweils auch als Thyristorplatz bezeichnet werden, werden zu einem Leistungshalbleiter-Ventilbaustein 28 gemäß Figur 2 zusammengesetzt. Dieser Leistungshalbleiter-Ventilbaustein 28 wird auch als Ventilabschnitt bezeichnet. Dieser Ventilabschnitt 28 weist neben den mehreren Thyristorplätzen 2 eine sättigbare Ventildrossel 30 und einen Kondensator 32 auf. Die Thyristorplatze 2 und die sättigbare Ventildrossel 30 sind elektrisch in Reihe geschaltet, wogegen der Kondensator 32 elektrisch parallel zu dieser Reihenschaltung geschaltet ist. Wenigstens ein solcher Ventilbaustein 28 wird beispielsweise für ein Ventil eines mehrpulsigen Stromrichters verwendet.

Durch diese erfindungsgemäße Ausgestaltung des Leistungshalbleiter-Bausteins 2 können diese nun in ein Freiluftgerüst gesteckt werden und untereinander gemäß einem Stromlaufplan eines Stromrichters elektrisch leitend miteinander verbunden werden. Somit ähnelt dieser Stromrichteraufbau dem Aufbau einer Kondensatorbatterie, deren Kondensatoren in ein Freiluftgerüst gesteckt sind. Auf ein spezielles Gebäude bzw. eine Ventilhalle bzw. einen Kessel kann nun verzichtet werden, wodurch insbesondere Stromrichter kleiner Leistung viel preiswerter werden.

Wenn anstelle des Leistungshalbleiterschalters 4 ein direkt lichtzündbarer Leistungshalbleiter verwendet wird, so entfällt die Thyristorelektronik 6 mit ihrer Vielzahl von elektronischen Bauelementen. Dadurch wird der Baustein 2 noch kompakter und preiswerter.

Dieser erfindungsgemäße Leistungshalbleiter-Baustein 2 kann auch bei einer Hochspannungs-Kondensatorbatterie verwendet werden, die aus einer Vielzahl von Kondensatoren besteht. Diese Kondensatoren sind in einem Freiluftgerüst angeordnet. Jedem dieser Kondensatoren kann ein Leistungshalbleiter-Baustein 2 elektrisch parallel und/oder mehreren Kondensatoren elektrisch in Reihe geschaltet sein. Diese Leistungshalbleiter-Bausteine 2 sind ebenfalls in einem Freiluftgerüst angeordnet. Somit erhält man eine kompakte veränderbare Hochspannungs-Kondensatorbatterie. Anstelle von Kondensatoren können auch Drosseleinheiten einer Drosseleinheit mit den Leistungshalbleiter-Bausteinen 2 kombiniert werden, wenn man eine kompakte veränderbare Drosselanordnung benötigt. Dadurch, daß die Bausteine 2 in einem Freilaufgerüst angeordnet werden können, besteht die Möglichkeit der kompakten Ausführungsform einer Hochspannungs-Kondensatorbatterie bzw. einer Drosselanordnung.

## Patentansprüche

1. Leistungshalbleiter-Baustein (2) mit wenigstens einem Leistungshalbleiterschalter, einer Kühleinrichtung (8), einer Steuerelektronik (6) und einem Entlastungsnetzwerk (10), die elektrisch und mechanisch miteinander verbunden sind und wobei diese Komponenten (4, 6, 8, 10) mit einem isolierenden Medium (12) zu einem massiven Block (14) vergossen sind, aus dem Anschlüsse (16, 18, 20, 22, 24, 26) des Leistungshalbleiterschalters (4), der Steuereinrichtung (6) und der Kühleinrichtung (8) herausragen.

2. Leistungshalbleiter-Baustein (2) nach Anspruch 1, wobei als isolierendes Medium (12) Kunststoff vorgesehen ist.

3. Leistungshalbleiter-Baustein (2) nach Anspruch 2, wobei als Kunststoff Epoxydharz verwendet wird.

4. Leistungshalbleiter-Baustein (2) nach Anspruch 1,wobei die Kühleinrichtung (8) wenigstens eine Kühldose, eine Spannvorrichtung und Kühlmittelleitungen umfaßt.

5. Leistungshalbleiter-Ventilbaustein (28) mit wenigstens einem Leistungshalbleiter-Baustein (2) nach Anspruch 1 und einer nichtlinearen Ventildrossel (30), die elektrisch in Reihe geschaltete sind, wobei dieser Reihenschaltung ein Kondensator (32) elektrisch parallel geschaltet ist.

6. Leistungshalbleiter-Modul, gekennzeichnet durch wenigstens zwei elektrisch in Reihe geschaltete Leistungshalbleiter-Bausteine (2) nach Anspruch 1.

7. Leistungshalbleiter-Baustein (2) nach Anspruch 1, wobei der Leistungshalbleiterschalter (4) elektrisch zündbar ist.

8. Leistungshalbleiter-Baustein (2) nach Anspruch 1, wobei der Leistungshalbleiterschalter (4) lichtzündbar ist.

9. Leistungshalbleiter-Baustein (2) nach Anspruch 1, wobei der Leistungshalbleiterschalter (4) ein abschaltbarer Leistungshalbleiterschalter ist.

## Claims

1. Power semiconductor module (2) having at least one power semiconductor switch, a cooling system (8), control electronics (6) and a relieving network (10), which are electrically and mechanically connected to each other, and with these components (4, 6, 8, 10) being cast with an insulating medium (12) to form a solid block (14), from which the connections (16, 18, 20, 22, 24, 26) of the power semiconductor switch (4), the control equipment (6), and the cooling system (8) protrude.

2. Power semiconductor module (2) according to claim 1, with plastics being provided as the insulating medium (12).

3. Power semiconductor module (2) according to claim 2, with epoxy resin being used as the plastics material.

4. Power semiconductor module (2) according to claim 1, with the cooling system (8) comprising at least one cooling box, a clamping fixture and coolant lines.

5. Power semiconductor valve module (28) having at least one power semiconductor module (2) according to claim 1 and a nonlinear valve reactor (30), which are connected electrically in series, with d capacitor (32) being connected electrically in parallel with this series circuit arrangement.

6. Power semiconductor module characterised by at least two power semiconductor modules (2) according to claim 1 connected electrically in series.

7. Power semiconductor module (2) according to claim 1, with the power semiconductor switch (4) being electrically firable.

8. Power semiconductor module (2) according to claim 1, with the power semiconductor switch (4) being light pulse firable.

9. Power semiconductor module (2) according to claim 1, with the power semiconductor switch (4) being an interruptible power semiconductor switch.

## Revendications

1. Module (2) à semistor de puissance, comportant au moins un commutateur à semistor de puissance, un dispositif (8) de refroidissement, une électronique (6) de commande et un réseau (10) de décharge, qui sont reliés entre eux de manière électrique et mécanique, ces composants (4, 6, 8, 10) étant scellés par un milieu (12) isolant en un bloc (14) plein dont font saillie des bornes (16, 18, 20, 22, 24, 26) du commutateur (4) à semistor de puissance, du dispositif (6) de commande et du dispositif (8) de refroidissement.

2. Module (2) à semistor de puissance suivant la revendication 1, dans lequel de la matière plastique est prévue comme milieu (12) isolant.

3. Module (2) à semistor de puissance suivant la revendication 2, dans lequel la résine époxy est utilisée comme matière plastique.

4. Module (2) à semistor de puissance suivant la revendication 1, dans lequel le dispositif (8) de refroidissement comporte au moins une boîte de refroidissement, un dispositif de serrage et des conduites d'agent réfrigérant.

5. Module (28) à valve à semistor de puissance, comportant au moins un module (2) à semistor de puissance suivant la revendication 1 et une inductance (30) de soupape non linéaire, qui sont branchés en série du point de vue électrique, ce circuit série étant branché en parallèle du point de vue électrique avec un condensateur (32).

6. Module à semistor de puissance, caractérisé par au moins deux modules (2) à semistor de puissance suivant la revendication 1 branchés en série du point de vue électrique.

7. Module (2) à semistor de puissance suivant la revendication 1, dans lequel le commutateur (4) à semistor de puissance peut être amorcé électriquement.

8. Module (2) à semistor de puissance suivant la revendication 1 dans lequel le commutateur (4) à semistor de puissance peut être amorcé par éclairage.

9. Module (2) à semistor de puissance suivant la revendication 1, dans lequel le commutateur (4) à semistor de puissance est un commutateur à semistor de puissance pouvant être déconnecté.
